Europäisches Patentamt

European Patent Office

Office européen des brevets

(11) Publication number: 0 339 871
A2

# EUROPEAN PATENT APPLICATION

(21) Application number: 89303936.2

(22) Date of filing: 20.04.89

(51) Int. Cl.4: H01L 23/48

(30) Priority: 29.04.88 US 188294

(43) Date of publication of application:
02.11.89 Bulletin 89/44

(84) Designated Contracting States:
AT BE CH DE ES FR GB GR IT LI LU NL SE

(71) Applicant: ADVANCED MICRO DEVICES, INC.
901 Thompson Place P.O. Box 3453
Sunnyvale, CA 94088(US)

(72) Inventor: Hatcher, Owen W., Jr.
605 Templeton Court
Sunnyvale California(US)

(74) Representative: Wright, Hugh Ronald et al
Brookes & Martin 52/54 High Holborn
London WC1V 6SE(GB)

(54) Corrosion tolerant bonding pad and method of fabricating same.

(57) A corrosion tolerant bonding pad for a semiconductor device includes an interconnect formed on the substrate of the semiconductor device, a passivating layer provided on the interconnect, the passivating layer having an aperture for exposing an enlarged bonding region of the interconnect, a barrier layer provided on the exposed enlarged bonding area of the interconnect and on portions of the passivating layer surrounding the bonding area, and a bonding layer provided on the barrier layer. The barrier layer is a non-corrosive, conductive material, for example, a compound of titanium and tungsten (TiW -- known as ti-tungsten).

EP 0 339 871 A2

## CORROSION TOLERANT BONDING PAD AND METHOD OF FABRICATING SAME

The present invention relates to bonding pads used to attach lead wires to an integrated circuit.

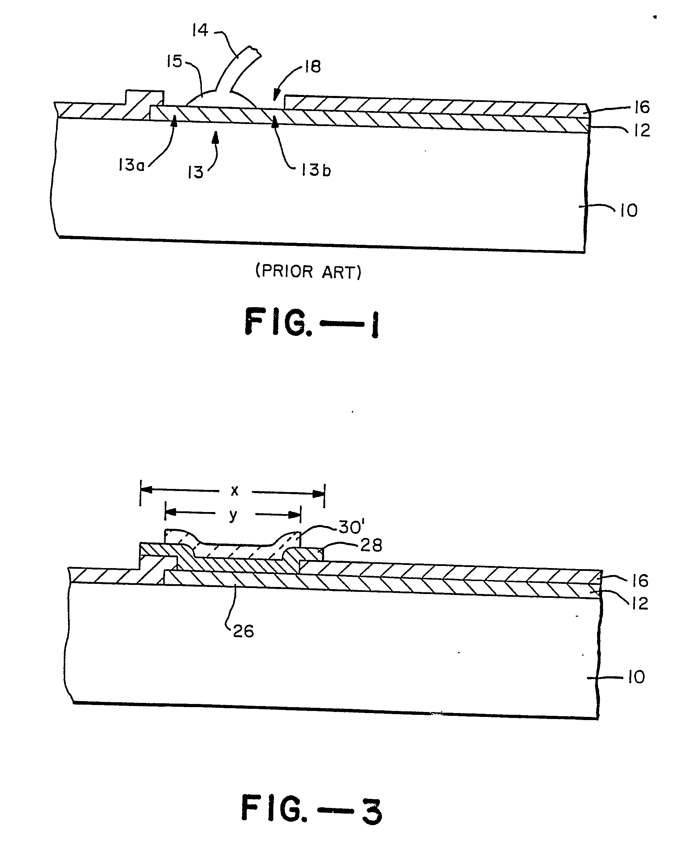

In conventional integrated circuits, as shown in the partial cross-section of Fig. 1, interconnects 12 provide electrical connections between individual devices (not shown) on the integrated circuit and extend to the edges of the integrated circuit where enlarged regions called bonding pads 13 are provided. Metal "lead" wires 14 are attached to the bonding pads 13 in order to apply power, signals, and other electrical interconnections to the integrated circuit. The interconnects 12 are usually formed of 90%-100% pure aluminum and lead wires 14 are usually formed of gold, but may also be formed of aluminum. Lead wires 14 are attached to the bonding pads 13 by thermal compressive bonding which creates a bonded region 15.

The interconnects 12 and bonding pads 13 are covered by passivation layers 16 formed of $SiO_2$, doped $SiO_2$, $Si_3N_4$, or a combination of these layers. Apertures 18 of approximately 16-20 $mil^2$ are provided through portions of the passivating layer 16 corresponding to the center portions of the bonding pads 13 which are usually 20-25 $mil^2$. Bonded region 15, however, covers only 30-70% of the portion of bonding pad 13 exposed by aperture 18. Thus, a portion of each bonding pad 13 remains exposed after the leads 14 are attached thereto.

Passivation layer 16 prevents corrosion of interconnect 12, but in the regions of aperture 18 where bonded region 15 does not cover bonding pad 13 the aluminum bonding pad 13 is subject to oxidation, or other corrosion. This oxidation or corrosion transforms aluminum bonding pad 13 into a non-conducting material, e.g., aluminum oxide or aluminum hydroxide. If the oxidation of bonding pad 13 occurs in region 13b, it will cause increased resistance between the bonding pad 13 and interconnect 12, and in the worst case an open circuit between bonding pad 13 and the remaining portion of interconnect 12.

In the case where the passivation layer 16 is doped $SiO_2$, moisture which enters the integrated circuit package combines with phosphorous, which is present as a dopant in the passivating layers 16, to form phosphoric acid which reacts with the exposed aluminum converting the aluminum to aluminum oxide or aluminum hydroxide. This phenomenon is facilitated by the direct contact between the exposed portion of bonding pad 13, particularly portion 13b, and passivating layer 16.

Other corrosion sources may be associated with the packaging material of an integrated circuit.

Generally, the packaging is a plastic material which may have components which cause corrosion. In addition, other sources of corrosive materials may exist in the integrated circuit itself or may occur as the result of fabrication or packaging processes.

## SUMMARY OF THE INVENTION

We will describe a corrosion tolerant bonding pad.

We will describe a corrosion resistant barrier layer on the enlarged portion of the interconnect to which a connection is to be made in order to prevent corrosion of the interconnect.

We will describe an arrangement to prevent or delay corrosion of the bonding pad structure, particularly the exposed bonding layer.

We will describe a physical separation between any exposed aluminum layers and phosphorous-doped passivating layers to reduce or eliminate corrosion by phosphoric acid.

In accordance with the present invention a corrosion tolerant bonding pad, comprising:
a conductive interconnect;
a passivating layer provided on said conductive interconnect, said passivating layer having an aperture which exposes a portion of said conductive interconnect;
a conductive barrier layer provided on said conductive interconnect in said aperture; and
a bonding layer provided on said barrier layer.

The barrier layer may be non-corrosive, conductive material, for example, a compound of titanium and tungsten (TiW -- known as ti-tungsten). To increase the physical separation between the passivating layer and the bonding layer, thereby reducing or eliminating any corrosion of the bonding layer by phosphoric acid formed from the phosphorous dopant in the passivating layer, the area of the bonding layer is made less than the area of the barrier layer.

A bonding pad in accordance with the present invention has the advantage that the bonding region of the interconnect is less likely to oxidize or otherwise corrode. The electrical connection between a lead wire and the interconnect is not affected by corrosion of the portions of the bonding layer not protected by the material used to bond the lead wire to the bonding layers, and thus the bonding pad is corrosion tolerant.

## BRIEF DESCRIPTION. OF THE DRAWINGS

Fig. 1 is a cross-sectional view of a conventional bonding pad;

Fig. 2A is a plan view of a corrosion tolerant bonding pad in accordance with the present invention;

Fig. 2B is a cross-sectional view taken along line B-B' in Fig. 2A; and

Fig. 3 is a cross-sectional view of an alternative embodiment of a corrosion tolerant bonding pad in accordance with the present invention.

## DESCRIPTION OF THE PREFERRED EMBODI-
## MENTS

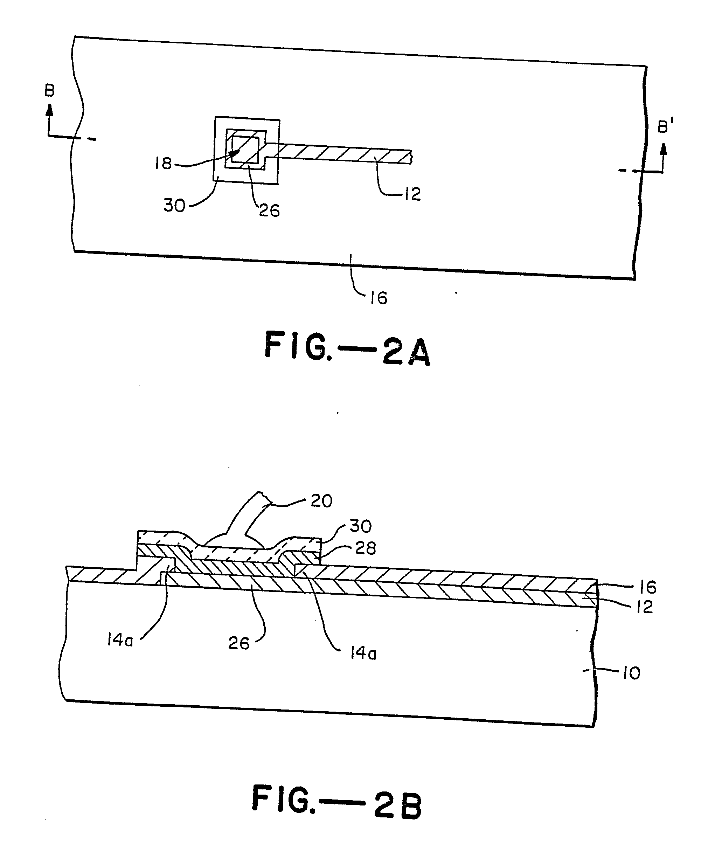

A corrosion tolerant bonding pad in accordance with the present invention and a method of fabricating same will be described with reference to Figs. 2A and 2B. It is to be understood that the materials, thicknesses, and structures described with respect to the preferred embodiments of the present invention are exemplary and are not intended to limit the scope of the invention. As used herein, the term "bonding pad" refers to any single or multi-layer structure useful in the electrical interconnection of an interconnect and a lead wire.

As shown in Figs. 2A and 2B, a substrate 10 has an interconnect 12 provided thereon. As in conventional semiconductor devices, interconnect 12 may be formed of aluminum or compounds of aluminum and materials such as copper and/or silicon, e.g. aluminum-copper, aluminum- silicon, and aluminum-copper-silicon. Alternatively, interconnect 12 may be formed of other materials or compounds which are electrical conductors and useful in fabricating semiconductor devices in accordance with techniques known in the semiconductor industry. Further, the interconnect 12 may be formed directly on substrate 10 or on other layers provided on substrate 10, for example, interconnect 12 may be provided on insulating layers which separate it from other underlying interconnects (not shown) in, for example, a dual metallization structure.

A passivating layer 16, formed by conventional techniques, is provided on interconnect 12 and has an aperture (or opening) 18 to expose an enlarged bonding area 26 of interconnect 12. To prevent oxidation or other corrosion of bonding area 26 of interconnect 12, a corrosion resistant, conductive barrier layer 28 is provided on bonding area 26 in aperture 18 of passivating layer 16. Examples of the materials which may be utilized to form barrier layer 28 are tungsten and titanium and compounds of these materials, or other materials which are not subject to significant oxidation or corrosion when exposed to phosphoric acid and other agents present in a packaged integrated circuit. In the preferred embodiment of the present invention the barrier layer is formed of a compound of titanium and tungsten (ti-tungsten or Tiw) and has a thickness of approximately 1000-2000Å.

To prevent exposure of bonding area 26 of interconnect 12 to oxidizing or other corrosive environments, barrier layer 28 is provided both in the entirety of aperture 18 and on portion 14a of passivating layer 14 surrounding aperture 18. Barrier layer 28 may be formed be co-sputtering from titanium and tungsten targets or electron beam (E-beam deposition. One important aspect of providing the barrier layer is to insure that an ohmic contact is provided with interconnect 12. Thus, oxidation of interconnect 12 prior to deposition of barrier layer 28 must be avoided and, if any oxidation does occur, the oxide should be removed by, for example, reverse sputtering.

A bonding layer 30 formed of, for example, aluminum, is provided on barrier layer 28, and lead wire 14 is attached to bonding layer 30 using conventional bonding techniques, for example, thermal compressive bonding. Bonding layer 30 may also be formed of gold. If the bonding layer 30 is gold, it could be fabricated by standard lift-off techniques. In the preferred embodiment bonding layer 30 is formed of 90%-100% pure aluminum and has a thickness of approximately $1\mu$m. However, thicknesses ranging from 0.25 to $2\mu$m may be used. Bonding layer 30 may be provided with the same techniques used to provide barrier layer 28. Again, an ohmic contact must be provided between barrier layer 28 and bonding layer 30.

Another characteristic of the material selected for barrier layer 28 is that it must not be penetrated by the material of bonding layer 30 during subsequent fabrication steps or at temperatures experienced in operation of the integrated circuit.

In accordance with the present invention corrosion of bonding area 26 of interconnect 12 is prevented, and even if bonding pad 30 corrodes, the portion of bonding pad 30 underlying bond 18 will be protected from corrosion, thereby preventing or substantially delaying increased resistance and/or open circuits between lead wires 14 and interconnects 12.

An alternative embodiment of the present invention will be described with reference to Fig. 3. In the alternative embodiment the bonding layer 30' has a smaller area than the barrier layer 28. For example, if the barrier layer 26 and bonding layer 30' are square and have respective dimensions x and y, the area $x^2$ of barrier layer 28 is less than the area $y^2$ of bonding layer 30'. The purpose of reducing the area of bonding layer 30' with respect to the area of barrier layer 28 is to increase the physical separation of the aluminum bonding layer 30' and passivating layer 16, thereby reducing or eliminating the possibility that phosphoric acid formed from the phosphorous dopant ions in the passivating layer will react with the aluminum of bonding layer 30'.

The reduced size of bonding layer 30' may be accomplished by two methods. As with other elements in integrated circuits, barrier layer 28 and bonding layer 30' are deposited as continuous layers which are patterned by standard photolithographic techniques. If a single mask is to be used to etch the patterns of both barrier layer 28 and bonding layer 30', the integrated circuit would first be subject to an etchant which etches the aluminum bonding layer 30', then to an etchant which etches the material of barrier layer 28, and thereafter to a second etching with an etchant for aluminum to cause lateral etching of bonding layer 30'. In this method the etchant for aluminum must be a selective etchant which does not etch the material of the barrier layer 28. The selectivity of the etchant may be provided by selecting appropriate etchants or by selecting materials for barrier layer 25 and bonding layer 30' which are not affected by the same etchants.

If separate masks are used to etch the patterns of barrier layer 28 and bonding layer 30', then the areas of the mask which are used to protect the barrier layer 28 and the bonding layer 30' during the etching process are selected to provide the desired difference in the area of barrier layer 30'.

The many features and advantages of the corrosion tolerant bonding pad of the present invention will be apparent to those of ordinary skill in the art. Thus, the following claims are intended to cover all modifications and equivalents falling within the scope of the invention.

## Claims

1. A corrosion tolerant bonding pad, comprising:
a conductive interconnect;
a passivating layer provided on said conductive interconnect, said passivating layer having an aperture which exposes a portion of said conductive interconnect;
a conductive barrier layer provided on said conductive interconnect in said aperture; and
a bonding layer provided on said barrier layer.

2. A corrosion tolerant bonding pad according to claim 1, wherein said barrier layer comprises a material selected from the group comprising titanium and tungsten and compounds of titanium and tungsten.

3. A corrosion tolerant bonding pad according to claim 1, wherein said barrier layer comprises a compound of titanium and tungsten (TiW).

4. A corrosion tolerant bonding pad according to claim 3, wherein said bonding layer comprises aluminum.

5. A corrosion tolerant bonding pad according to claim 4, wherein:
said barrier layer has a thickness of 1000-2000Å; and
said bonding layer has a thickness of approximately 1μm.

6. A corrosion tolerant bonding pad according to claim 1, wherein said barrier layer is provided on a portion of said passivating layer surrounding said aperture.

7. A corrosion tolerant bonding pad according to claim 1, wherein said barrier layer has an area, said bonding layer has an area, and the area of said bonding layer is less than the area of said barrier layer.

8. A corrosion tolerant bonding pad according to claim 4, wherein said barrier layer has an area, said bonding layer has an area, and the area of said bonding layer is less than the area of said barrier layer.

9. A corrosion tolerant bonding pad according to claim 7, wherein said barrier layer is provided on portions of said passivating layer surrounding said aperture in said passivating layer.

10. A method of fabricating a corrosion tolerant bonding pad for an interconnect formed on a substrate, comprising the steps of:
(a) providing a passivating layer on the interconnect;
(b) exposing a portion of the interconnect through an opening in the passivating layer;
(c) providing a barrier layer on the portion of the interconnect corresponding to the opening in the passivating layer; and
(d) providing a bonding layer on the barrier layer.

11. A method according to claim 10, wherein said step (c) further comprises providing the barrier layer on portions of the passivating layer surrounding the opening in the passivating layer.

12. A method according to claim 11, wherein said step (c) comprises providing a titanium and tungsten barrier layer.

13. A method according to claim 12, wherein said step (d) comprises providing an aluminum bonding layer.

14. A method according to claim 13, wherein said step (d) comprises providing a 90%-100% pure aluminum bonding layer having a thickness of 1μm.

15. A method according to claim 13, wherein said step (d) further comprises providing a bonding layer having an area which is less than the area of the barrier layer.

16. A corrosion tolerant bonding pad for a semiconductor device, comprising:
an interconnect for carrying an electrical signal;
a passivating layer provided on a first portion of said interconnect;
a barrier layer provided on a second portion of said interconnect and on a portion of said passivating layer in regions where said first and second portions of said interconnect are contiguous; and
a bonding pad provided on said corrosion tolerant layer.

17. A corrosion tolerant bonding pad according to claim 16, wherein:
said interconnect comprises aluminum;
said barrier layer comprises titanium and tungsten; and
said bonding pad comprises aluminum.

18. A corrosion tolerant bonding pad according to claim 17 wherein said bonding pad comprises 90%-100% pure aluminum.

19. A corrosion tolerant bonding pad according to claim 18, wherein said bonding pad has a thickness of approximately 1$\mu$m.

20. A corrosion tolerant bonding pad according to claim 10, wherein said barrier layer has an area, said bonding layer has an area, and the area of said bonding layer is less than the area of said barrier layer.

21. A corrosion tolerant bonding pad according to claim 17, wherein said barrier layer has an area, said bonding layer has an area, and the area of said bonding layer is less than the area of said barrier layer.

22. A semiconductor device formed on a substrate, comprising:
at least one active region provided in said substrate;
an interconnect for providing an electrical interconnection with said active region, said interconnect having an enlarged bonding area;
a passivation layer provided on said interconnect, said passivating layer having an aperture exposing said bonding area of said interconnect;
a tungsten-titanium barrier layer provided on said bonding area of said interconnect in said aperture and on a portion of said passivating layer surrounding said aperture; and
a bonding layer provided on said barrier layer.

23. A semiconductor device according to claim 30, wherein:
said interconnect comprises aluminum;
said barrier layer comprises titanium-tungsten; and
said bonding layer comprises aluminum.

24. A semiconductor device according to claim 23, wherein said barrier layer has an area, said bonding layer has an area, and the area of said bonding layer is less than the area of said barrier layer.

(PRIOR ART)

# FIG.—1

# FIG.—3

FIG.—2A

FIG.—2B